# DEMANDE DE BREVET EUROPEEN

(11) **EP 2 302 671 A1**
(43) Date de publication de la demande: **30.03.2011**
(21) Numéro de dépôt: 10175584.1
(22) Date de dépôt: 07.09.2010
(51) Int. Cl.: H01L 21/762

(54) **Procédé de collage et de transfert d'une couche**

(30) Priorité: 28.09.2009 FR 0956700
(71) Demandeur: S.O.I. Tec Silicon on Insulator Technologies, 38190 Bernin (FR)
(72) Inventeur: Lagahe Blanchard, Chrystelle, 38920, Crolles (FR)
(74) Mandataire: Bomer, Françoise Marie

(57) **Abrégé**

L'invention concerne un procédé de collage et de transfert d'une couche de matériau (12) issue d'un substrat donneur (1) sur un substrat receveur (2), utilisé lors de la fabrication d'un substrat destiné notamment à des applications dans les domaines de l'électronique, l'optique ou l'opto-électronique.

Ce procédé comprend les étapes suivantes :
- coller par adhésion moléculaire ledit substrat receveur (2) et un substrat (1) donneur,
- appliquer un traitement thermique à l'empilement précité pour consolider l'interface de collage (5),
- amincir le substrat donneur (1) par meulage,
- effectuer un détourage annulaire du substrat donneur (1) et d'une partie du substrat receveur (2),
- après les étapes précitées, effectuer une étape de gravure chimique de la surface exposée de la partie restante du substrat donneur (1) et de la surface exposée du substrat receveur (2).

## Description

L'invention se situe dans le domaine de la fabrication des substrats destinés à des applications en électronique, en optique et en opto-électronique.

La présente invention concerne plus particulièrement un procédé de collage et de transfert d'une couche de matériau sur un substrat, mis en oeuvre lors de la fabrication de substrats destinés aux applications précitées.

Lors d'un procédé de transfert de ce type, on colle l'un contre l'autre par adhésion moléculaire, deux substrats dits respectivement "donneur" et "receveur", puis l'on amincit le substrat donneur, par exemple par meulage ou polissage, de sorte que l'on transfère une partie du substrat donneur sur le substrat receveur.

Un tel procédé permet d'obtenir des substrats multicouches de type quelconque, par exemple comprenant au moins deux couches de matériaux, semiconducteurs ou non.

Un tel procédé de transfert permet aussi d'obtenir un substrat comprenant une ou plusieurs couches intermédiaires intercalées entre la couche superficielle prélevée du substrat donneur et la couche de base correspondant au substrat receveur. Il permet également de transférer une couche comportant tout ou partie d'un ou de plusieurs microcomposants d'un substrat donneur, vers un substrat receveur, comme cela est illustré par exemple dans le document US 5 234 860.

Un exemple particulier de ce type de substrat multicouche est constitué par l'un de ceux connus de l'homme du métier sous l'acronyme "SeOI", qui signifie en anglais "*Semi-conductor On Insulator*" pour "Semi-conducteur sur Isolant".

On a constaté que les substrats fabriqués par ces techniques de transfert présentent généralement une zone annulaire dite de "couronne périphérique", dans laquelle le collage entre les couches est inexistant ou de moins bonne qualité, du fait de l'existence de chanfreins sur les substrats donneur et receveur utilisés et couramment disponibles. La présence de ces chanfreins conduit à une faible énergie de collage sur les bords des substrats assemblés, voire à une absence totale d'adhésion.

En conséquence, l'étape d'amincissement mécanique, traditionnellement mise en oeuvre pour former la couche transférée a tendance à provoquer une délamination partielle périphérique de cette couche au niveau de l'interface de collage. De plus, les efforts thermomécaniques appliqués au substrat lors de l'étape d'amincissement peuvent induire un phénomène d'écaillage en périphérie de la couche transférée, de sorte que cette couche transférée présente alors un contour irrégulier.

L'existence de cette délamination partielle et de ce contour irrégulier de la couche transférée crée un risque de contamination particulaire des équipements ou des substrats eux mêmes, des morceaux de la couche pouvant en effet se rompre au cours de traitements ultérieurs.

Ce risque est encore accentué dans le cas où le procédé de collage des deux substrats donneur et receveur est effectué à basse température. Ceci est le cas, par exemple, lorsque les matériaux mis en contact ne supportent pas les températures élevées (par exemple les substrats "SOQ" pour "*Silicon On Quartz*" ou "SOS" pour "*Silicon On Sapphire"*) ou lorsqu'au moins l'un des substrats assemblés contient des composants électroniques ou opto-électroniques par exemple.

On connait déjà d'après le document JP 09-017984 un procédé de fabrication d'un substrat SOI.

Ce document fait référence à un procédé de l'état de la technique qui consiste à
- coller par adhésion moléculaire, un substrat donneur recouvert d'une couche d'isolant avec un substrat receveur,
- effectuer un détourage annulaire de la totalité du substrat donneur et d'une partie du substrat receveur,
- graver la partie du substrat receveur écrouie par l'étape de détourage,
- et ensuite meuler une partie du substrat donneur pour obtenir la couche superficielle de la structure SOI.

Or, ce procédé à tendance à amplifier le phénomène de délamination partielle périphérique de la couche transférée au niveau de l'interface de collage. En effet, dans le cas d'une structure collée dont la consolidation n'a été faite qu'à basse température, les contraintes mécaniques introduites lors du détourage mécanique annulaire de la totalité du substrat donneur et d'une partie du substrat receveur peuvent mener à des décollements localisés ou étendus de l'interface de collage. Les contraintes thermomécaniques sur la structure sont en effet importantes lors de cette étape.

Un autre procédé de détourage est décrit dans ce même document JP 09-017984. Il comporte les étapes suivantes :
- détourage d'une partie seulement du substrat donneur jusqu'à environ 50 µm avant l'interface de collage, de façon à ne pas endommager le substrat receveur,
- gravure sélective successive de la portion annulaire résiduelle du substrat donneur à l'aide d'une solution de TMAH (tétraméthylammonium hydroxyde), puis de l'oxyde.

Ceci permet de ne pas attaquer le substrat receveur.

Toutefois, dans certains cas de structures collées, notamment dans le cas où le substrat donneur est un substrat de type SOI comprenant une couche d'oxyde enterrée et dont la couche superficielle inclus des microcomposants (circuits), la gravure sélective du silicium du substrat donneur préalablement partiellement détouré va s'arrêter au niveau de la couche d'oxyde enterrée du substrat donneur et à la base de la couche incluant le circuits ; ainsi, il va rester une couche « faiblement collée et irrégulière » de 5 à 10 µm (épaisseur du circuit) non éliminée en périphérie de la structure.

On connait également d'après le document EP 0 964 436, en procédé de fabrication d'un substrat SOI qui comprend des étapes de collage d'un substrat donneur, recouvert d'une couche d'oxyde, sur un substrat receveur et de transfert d'une partie d'une couche issue de ce substrat donneur, sur ledit substrat receveur.

Toutefois, dans ce procédé, le substrat receveur n'est pas détouré, ni gravé. De plus, dans ce procédé l'étape de gravure est effectuée avant l'étape d'amincissement. En conséquence, cette dernière étape a pour effet de créer une contamination particulaire, ce qui est contraire à l'objectif recherché dans la présente invention.

On connait aussi d'après le document US 2006/0055003, un procédé de formation de sites de piégeage dans un substrat SOI.

Ce procédé comprend également une étape de collage de deux substrats donneur et receveur, suivie d'une étape de détourage effectuée uniquement sur la périphérie du substrat donneur, mais stoppée avant d'atteindre l'interface de collage entre les deux substrats.

Ce procédé s'achève également par l'étape d'amincissement, avec les mêmes inconvénients que précité.

Enfin, le document FR 2 935 535 décrit un procédé de détourage mixte d'une structure comprenant un substrat donneur, collé sur un substrat receveur.

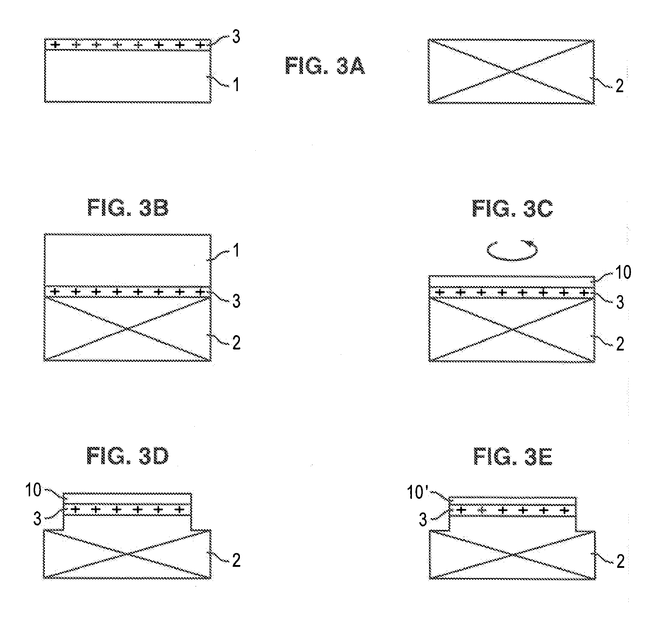

Si l'on considère que l'étape de la figure 3D correspond à l'étape de détourage de la présente invention et que l'étape de la figure 3E correspond à l'étape de gravure, alors on constate que l'étape de détourage n'est pas menée jusqu'à retirer une partie du substrat receveur.

Inversement, si l'on considère que les étapes des figures 3D et 3E constituent de façon groupée une étape de détourage du substrat donneur et du substrat receveur, alors cette étape n'est pas suivie ultérieurement d'une étape supplémentaire de gravure, telle que mentionnée dans la revendication 1.

La présente invention est donc nouvelle par rapport au contenu de ce document.

L'invention a pour but de résoudre les inconvénients précités de l'état de la technique et de fournir un procédé de transfert d'une couche sur un substrat receveur, qui inclut une étape de détourage, ce procédé:
- permettant d'éviter les problèmes d'écaillage et de délamination du substrat final et la formation d'une couche transférée de contour irrégulier,
- étant plus simple, plus rapide à mettre en oeuvre et moins coûteux que les procédés déjà connus de l'état de la technique.

A cet effet, l'invention concerne un procédé de collage et de transfert d'une couche de matériau issue d'un substrat donneur, sur un substrat receveur, utilisé lors de la fabrication d'un substrat destiné notamment à des applications dans les domaines de l'électronique, l'optique ou l'opto-électronique.

Conformément à l'invention, ce procédé comprend les étapes suivantes :
- coller par adhésion moléculaire ledit substrat receveur et un substrat donneur,
- appliquer un traitement thermique à l'empilement précité pour consolider l'interface de collage,
- amincir le substrat donneur par meulage,
- effectuer un détourage annulaire du substrat donneur et d'une partie du substrat receveur,
- après les étapes précitées, effectuer une étape de gravure chimique de la surface exposée de la partie restante du substrat donneur et de la surface exposée du substrat receveur.

Selon d'autres caractéristiques avantageuses et non limitatives de l'invention, prises seules ou en combinaison ;
- l'amincissement par meulage est effectué avant le détourage ;
- l'amincissement par meulage est effectué après le détourage ;
- des composants électroniques sont formés dans et/ou sur ledit substrat donneur et/ou ledit substrat receveur avant le collage ;
- le substrat donneur est un substrat massif ;
- l'étape de gravure chimique est interrompue après enlèvement de la zone écrouie lors de l'étape de meulage ;
- l'étape de gravure chimique est suivie d'une étape de polissage de la face exposée de la couche de matériau issue du substrat donneur ;
- le substrat donneur est un substrat du type "silicium sur isolant SOI", comprenant un substrat support en silicium, une couche enterrée d'isolant et une couche superficielle également en silicium ;
- le meulage comprend l'élimination d'une partie du substrat support, et l'étape de gravure est interrompue après enlèvement du résidu dudit substrat support ;
- une couche d'oxyde est formée ou déposée sur ledit substrat donneur et/ou sur ledit substrat receveur avant le collage ;
- la couche d'oxyde est planarisée pour résorber la topologie éventuelle du ou des composants présents à la surface et conférer à la surface les caractéristiques requises pour le collage par adhésion moléculaire ;
- le meulage est effectué jusqu'à ce que l'épaisseur du substrat donneur atteigne 50 µm environ ;
- le substrat receveur est détouré sur une profondeur comprise entre 2 et 10 µm environ à compter de sa surface ;
- les substrats donneur et receveur sont formés de silicium et la solution de gravure est une solution de tétraméthylammonium hydroxyde TMAH présentant une concentration de 25% en poids dans de l'eau.

D'autres caractéristiques et avantages de l'invention apparaîtront de la description qui va maintenant en être faite, en référence aux dessins annexés, qui en représentent, à titre indicatif mais non limitatif, plusieurs modes de réalisation possibles.

Sur ces dessins :
- les figures 1A à 1F sont des vues schématiques représentant les différentes étapes d'un premier mode de réalisation du procédé de collage et de transfert conforme à l'invention, et
- les figures 2A à 2F sont des vues schématiques représentant les différentes étapes d'un deuxième mode de réalisation du procédé de collage et de transfert conforme à l'invention, et
- les figures 3A à 3E sont des vues schématiques représentant les différentes étapes d'un troisième mode de réalisation du procédé de collage et de transfert conforme à l'invention.

Le procédé conforme à l'invention s'applique au collage de tout type de substrats et au transfert de couches de différentes natures issues de ces substrats.

L'invention trouve toutefois une application particulière dans le cas où les matériaux utilisés pour fabriquer tout ou partie de ces substrats ne peuvent supporter des températures élevées, notamment supérieures à 450°C. Par "matériaux utilisés pour fabriquer tout ou partie de ces substrats", on entend une ou plusieurs des couches les constituant ou bien un composant électronique formé dans et/ou sur au moins l'un de ces substrats.

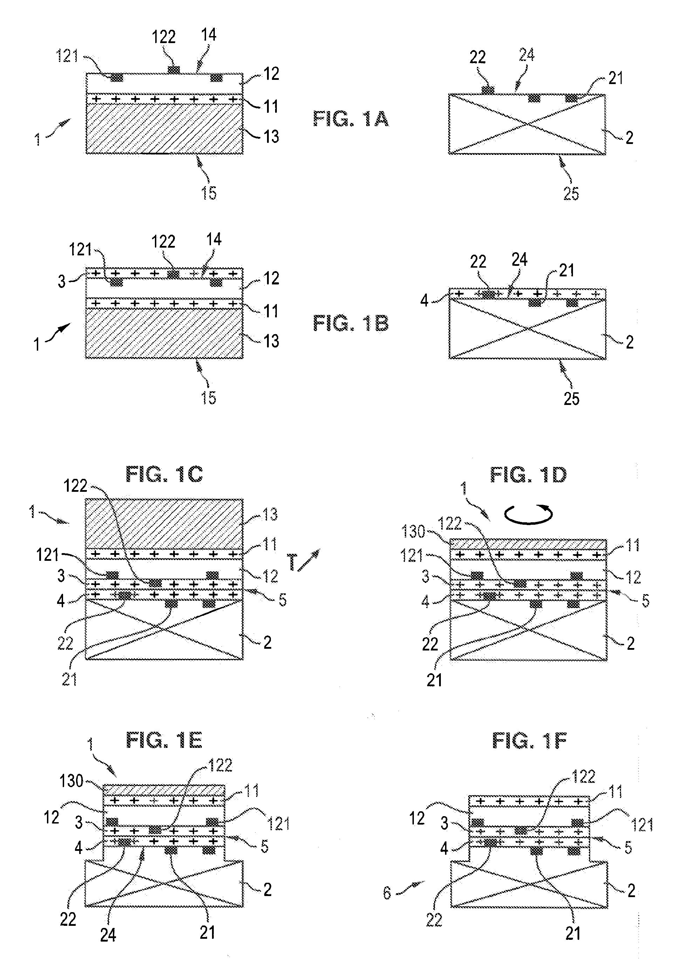

Un premier mode de réalisation va maintenant être décrit en liaison avec la figure 1.

En se reportant à la figure 1A, on peut voir un premier substrat 1 dit "donneur", du type "semi-conducteur sur isolant" (SeOI), qui comprend une couche d'isolant 11 intercalée (enterrée) entre une couche superficielle 12 et un support 13, cette couche 12 et ce support 13 étant réalisés en matériau semi-conducteur.

De préférence, la couche d'isolant 11 est une couche d'oxyde.

Une application particulière de ce procédé consiste à utiliser un substrat donneur de type SOI, dans lequel les couches 12 et 13 sont réalisées en silicium et la couche 11 en oxyde de silicium SiO₂.

On peut également voir sur la figure 1A, un second substrat, dit "receveur", référencé 2.

Sur les figures 1A à 1F, on a représenté le cas où des composants électroniques sont présents dans certaines couches des substrats donneur et receveur, toutefois, le procédé peut s'appliquer à des substrats n'en comprenant pas.

Lorsqu'ils sont présents, ces composants électroniques peuvent avoir été formés dans et/ou sur ladite couche superficielle 12 et/ou dans et/ou sur ledit substrat receveur 2.

Ces composants électroniques sont par exemple des circuits, typiquement des circuits de type CMOS, d'après la terminologie anglaise de "Complementary Metal Oxide Semiconductor".

Les composants formés dans la couche superficielle 12 portent la référence 121 et ceux formés dessus la référence 122, tandis que les composants formés dans le substrat receveur 2 portent la référence 21 et ceux formés dessus la référence 22.

Les composants 21 et/ou 22 du substrat support 2 peuvent avoir été formés directement dans ou sur ce substrat ou avoir fait l'objet d'un précédent transfert de couches, comme cela est le cas dans les empilements de circuits en trois dimensions, connus de l'homme du métier sous le nom "d'empilement 3D".

Le substrat donneur 1 présente deux faces opposées, à savoir une face 14, dite "avant", et une face opposée 15, dite "arrière". De façon similaire, le substrat receveur 2 comprend une face avant 24 et face arrière 25.

Comme on peut le voir sur la figure 1B, une couche d'oxyde est formée ou déposée sur la face avant 14 du substrat donneur 1 et/ou sur la face avant 24 du substrat receveur 2. Ces couches d'oxyde sont référencées respectivement 3 et 4.

Ces couches d'oxyde 3, 4 sont formées par oxydation thermique et/ou dépôt par des techniques de dépôt chimique en phase vapeur (CVD).

Dans le cas du substrat support 2, on notera que la couche d'oxyde 4 pourrait l'encapsuler complètement, bien que cela n'ait pas été représenté sur les figures.

De façon avantageuse, dans le cas où les composants électroniques sont présents, les couches d'oxyde 3 et/ou 4 sont planarisées, afin de résorber la topologie liée à la présence des composants et conférer à la surface les caractéristiques requises ultérieurement pour un collage par adhésion moléculaire.

La figure 1C représente l'étape de collage des deux substrats 1 et 2, effectuée de façon que la ou les couches d'oxyde de 3, 4 soient intercalées entre ces deux substrats.

Après le collage, un traitement thermique est appliqué afin de consolider l'interface de collage référencée 5.

Dans le cas illustré sur les figures 1A à 1F, où les substrats 1 et 2 comprennent des composants électroniques, la température de ce traitement thermique est relativement modeste, de préférence comprise entre 300° C et 400° C environ, afin d'éviter la dégradation de ces composants.

Conformément à une première variante de réalisation du procédé de l'invention, représenté sur les figures 1D à 1F, l'étape suivante consiste à effectuer un amincissement par meulage du support 13, de façon à n'en conserver qu'une couche de faible épaisseur 130, dont l'épaisseur est de préférence comprise entre 10 et 50 micromètres.

On procède ensuite à une étape de détourage, (voir figure 1 E), qui consiste à éliminer le bord annulaire périphérique du substrat donneur 1, des couches d'oxyde 3, 4 éventuellement présentes et d'une partie du substrat receveur 2.

La profondeur de ce détourage dans le substrat receveur 2 est de préférence comprise entre 2 et 10 micromètres environ à compter de sa face avant 24, c'est-à-dire sa face orientée vers l'interface de collage 5.

Cette étape a pour but d'obtenir un bord net, sans écailles, à la périphérie de la couche transférée.

Pour ce faire, le substrat receveur 2 est fixé sur un support rotatif et une roue de meulage, elle aussi animée d'un mouvement de rotation est amenée au contact de la périphérie de l'empilement de couches précitées. Cette étape de détourage peut ainsi être effectuée à l'aide d'équipements classiques de détourage, connus de l'homme du métier sous la dénomination anglaise d'équipement de « edge grinding » ou encore « edge trimming » en anglais).

L'étape de détourage peut éventuellement comporter une ou plusieurs étapes de profondeur et de largeurs différentes.

Enfin, la dernière étape du procédé, représentée sur la figure 1F, consiste à effectuer une gravure sélective de la couche de matériau semi-conducteur résiduelle 130 présente sur le dessus de l'empilement de couches.

Cette gravure peut être effectuée à l'aide de différentes solutions de gravure connues de l'homme du métier.

Toutefois, dans le cas particulier où les couches à graver sont en silicium, cette gravure est effectuée par exemple à l'aide d'une solution de type NaOH ou KOH, ou de préférence à l'aide d'une solution chimique de TMAH (qui désigne une solution de tetramétylammonium hydroxyde).

De préférence, on utilise une solution de TMAH dont la concentration est de 25% en poids dans de l'eau, à une température typiquement comprise entre 70°C et 90°C. La solution de TMAH est une solution de gravure du silicium et présente une forte sélectivité vis-à-vis de l'oxyde. La couche d'isolant 11 sert alors de couche d'arrêt de gravure.

A titre d'exemple, une gravure à l'aide d'une solution de TMAH dure typiquement de 1 minute à 2 heures en considérant que la vitesse d'attaque de la couche semi-conductrice 130 est de l'ordre de 25 à 30 micrométres/h.

Cette étape de gravure a également pour objectif de nettoyer et de lisser le bord détouré. En effet, le détourage mécanique provoque une augmentation de la rugosité de la surface traitée et génère un grand nombre de particules. La gravure permet de lisser la surface et de nettoyer le bord détouré, afin d'éviter toute contamination lors des étapes technologiques mises en oeuvre ultérieurement.

Par ailleurs, le procédé conforme à l'invention permet d'éviter le recours à l'acide fluorhydrique HF utilisé dans certains procédés de l'art antérieur, et qui accroit la délamination des couches et grave les oxydes.

On obtient à l'issue de l'étape représentée sur la figure 1F, un substrat final référencé 6, qui comprend le substrat receveur 2 sur lequel la couche superficielle 12 a été transférée. La couche d'isolant 11 est conservée ou non suivant les applications visées.

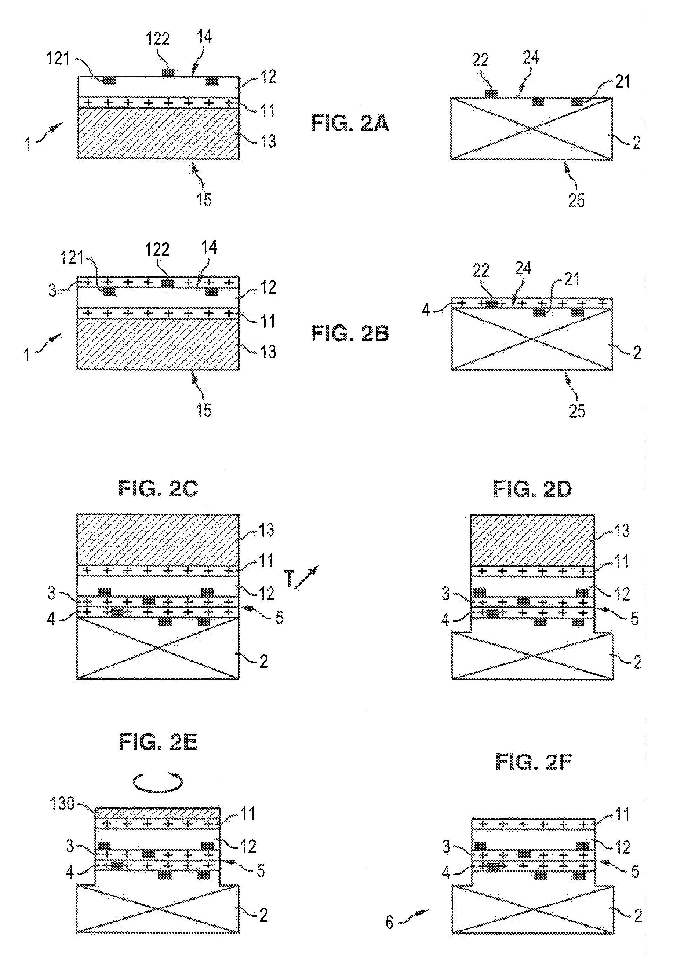

Les figures 2A à 2F illustrent une variante de réalisation du procédé qui a été décrit en liaison avec les figures 1A à 1F.

Les figures 2A à 2C sont identiques aux figures 1A à 1C et ne seront pas décrites de nouveau. Les éléments identiques portent les mêmes références numériques.

Ce procédé diffère du précédent en ce que le détourage est effectué avant l'étape de meulage du support 13. Ce détourage est illustré sur la figure 2D.

On procède ensuite au meulage du support 13 détouré, jusqu'à obtenir la couche 130, d'une épaisseur comprise entre 10 et 50 micromètres, comme précédemment décrit.

L'étape représentée sur la figure 2F correspond à la gravure, effectuée selon les mêmes modalités et avec les mêmes résultats que celle décrite pour le premier mode de réalisation de l'invention.

Dans ces deux modes de réalisation de l'invention, on notera que l'étape d'amincissement (figure 1D ou 2E) est toujours effectuée en gardant un minimum d'épaisseur du substrat donneur 13. L'avantage de ce séquençage est que la surface active finale de la couche transférée sur le substrat receveur 2 n'est jamais exposée lors de l'étape de détourage et est donc protégée des éventuelles contaminations particulaires ou rayures.

Une troisième variante de réalisation va maintenant être décrite en liaison avec les figures 3A à 3E. Il diffère des deux précédents en ce que les substrats donneur 1 et receveur 2 sont des substrats massifs. Le substrat donneur 1 est en outre recouvert d'une couche d'oxyde 3. Les éléments communs aux mode de réalisation précédents portent les mêmes références.

Après l'étape de collage représentée sur la figure 3B, on procède à un traitement thermique de l'empilement précité pour consolider l'interface de collage 5. Ce traitement peut être mené jusqu'à une température de 1100°C pendant 2 heures puisque les substrats 1 et 2 ne comprennent pas de composants électroniques et bien entendu dans la mesure où la nature des matériaux les constituant le permet.

On procède ensuite aux étapes d'amincissement par meulage (figure 3C), détourage (figure 3D) et gravure (figure 3E) dans les conditions décrites précédemment. La couche amincie du substrat donneur 1 porte la référence 10.

La gravure est interrompue dans ce cas à la fin de la durée de gravure nécessaire pour enlever la zone écrouie lors du meulage. La couche amincie par meulage, nettoyée par la gravure et débarrassée de sa zone écrouie porte la référence 10', Une fois encore, on notera que grâce au séquençage du procédé de l'invention, la surface de cette couche active 10' ne s'est jamais trouvée exposée lors du détourage et est restée protégée.

On donnera ci-après deux exemples de réalisation de l'invention.

### Exemple 1 : Fabrication d'un SOI comprenant des composants électroniques.

On a oxydé un substrat receveur en silicium et on a déposé une couche d'oxyde à basse température (entre 200°C et 500°C) sur un substrat donneur de type SOI comportant des composants électroniques.

On a planarisé le substrat donneur jusqu'à l'obtention d'un état de surface compatible avec un collage direct par adhésion moléculaire, c'est à dire jusqu'à obtenir une rugosité inférieure à 3 Å RMS (3 angströms) pour une largeur de balayage de 2 µm par 2 µm.

Après un nettoyage et une activation de surface, les deux substrats ont été assemblés. La structure collée a ensuite subi un traitement thermique à 350°C pendant 1 heure, afin de consolider l'interface de collage.

La face arrière du substrat donneur a alors été amincie par meulage ("*grinding*" en anglais) jusqu'à environ 35 µm. L'étape de détourage a ensuite été opérée à environ 3 mm du bord du substrat.

Cette structure a alors été plongée dans une solution de TMAH à 80°C, pendant 1h30, ce qui permet la gravure sélective du silicium vis-à-vis de l'oxyde jusqu'au retrait total de l'épaisseur de silicium résiduelle (issue de la partie arrière de support mécanique du substrat donneur SOI).

### Exemple 2 : Fabrication d'un SOI à partir d'un substrat donneur massif.

Après avoir procédé à l'oxydation d'un substrat receveur en silicium, on l'a collé avec un substrat donneur également en silicium.

On a soumis l'ensemble à un recuit de stabilisation du collage, par un traitement thermique à 1100°C pendant 2 heures, sous oxygène.

On a ensuite procédé à l'amincissement du substrat donneur puis au détourage de l'empilement sur 0,5 à 3 mm de large, et 2 à 10 micromètres de profondeur dans le support.

Ensuite, on a effectué une gravure à l'aide de TMAH (concentration 25% en poids dans de l'eau, température 60°C), de manière à éliminer la zone écrouie par l'étape d'amincissement, c'est à dire la surface exposée du reliquat de substrat donneur, et à traiter les faces exposées par l'étape de détourage du substrat receveur. Cette étape de gravure conduit à un enlèvement d'environ 0,5 à 2 micromètres d'épaisseur.

Enfin, on a procédé à un polissage final de la structure SOI, pour obtenir une couche de silicium superficielle d'une épaisseur comprise entre 3 et 100 micromètres.

## Revendications

1. Procédé de collage et de transfert d'une couche de matériau (10, 12) issue d'un substrat donneur (1), sur un substrat (2) receveur, utilisé lors de la fabrication d'un substrat (6) destiné notamment à des applications dans les domaines de l'électronique, l'optique ou l'opto-électronique, ce procédé étant **caractérisé en ce qu'**il comprend les étapes suivantes :
- coller par adhésion moléculaire ledit substrat receveur (2) et un substrat (1) donneur,
- appliquer un traitement thermique à l'empilement précité pour consolider l'interface de collage (5),
- amincir le substrat donneur (1) par meulage,
- effectuer un détourage annulaire du substrat donneur (1) et d'une partie du substrat receveur (2),
- après les étapes précitées, effectuer une étape de gravure chimique de la surface exposée de la partie restante du substrat donneur (1) et de la surface exposée du substrat receveur (2).

2. Procédé selon la revendication 1, **caractérisé en ce que** l'amincissement par meulage est effectué avant le détourage.

3. Procédé selon la revendication 1, **caractérisé en ce que** l'amincissement par meulage est effectué après le détourage.

4. Procédé selon l'une des revendications précédentes, **caractérisé en ce que** des composants électroniques (121, 122, 21, 22) sont formés dans et/ou sur ledit substrat donneur et/ou ledit substrat receveur (2) avant le collage.

5. Procédé selon l'une des revendications précédentes, **caractérisé en ce que** le substrat donneur (1) est un substrat massif.

6. Procédé selon la revendication 5, **caractérisé en ce que** l'étape de gravure chimique est interrompue après enlèvement de la zone écrouie lors de l'étape de meulage.

7. Procédé selon la revendication 6, **caractérise en ce que** l'étape de gravure chimique est suivie d'une étape de polissage de la face exposée de la couche de matériau issue du substrat donneur (1).

8. Procédé selon l'une des revendications 1 à 4, **caractérisé en ce que** le substrat donneur (1) est un substrat du type "silicium sur isolant SOI", comprenant un substrat support (13) en silicium, une couche enterrée d'isolant (11) et une couche superficielle (12) également en silicium.

9. Procédé selon la revendication 8, **caractérisé en ce que** le meulage comprend l'élimination d'une partie du substrat support (13), et **en ce que** l'étape de gravure est interrompue après enlèvement du résidu (130) dudit substrat support (13).

10. Procédé selon l'une des revendications précédentes, **caractérisé en ce qu'**une couche d'oxyde (3, 4) est formée ou déposée sur ledit substrat donneur (1) et/ou sur ledit substrat receveur (2) avant le collage.

11. Procédé selon les revendications 4 et 10, **caractérisé en ce que** la couche d'oxyde (3, 4) est planarisée pour résorber la topologie éventuelle du ou des composants (121, 122, 21, 22) présents à la surface et conférer à la surface les caractéristiques requises pour le collage par adhésion moléculaire.

12. Procédé selon l'une des revendications précédentes, **caractérisé en ce que** le meulage est effectué jusqu'à ce que l'épaisseur du substrat donneur (1) atteigne 50 µm environ.

13. Procédé selon l'une des revendications précédentes, **caractérisé en ce que** le substrat receveur (2) est détouré sur une profondeur comprise entre 2 et 10 µm environ à compter de sa surface.

14. Procédé selon l'une des revendications précédentes, **caractérisé en ce que** les substrats donneur et receveur sont formés de silicium et **en ce que** la solution de gravure est une solution de tétraméthylammonium hydroxyde TMAH présentant une concentration de 25% en poids dans de l'eau.
